# EUROPEAN PATENT APPLICATION

(11) **EP 1 009 042 A2**
(43) Date of publication of application: **14.06.2000**
(21) Application number: 99203961.0
(22) Date of filing: 25.11.1999
(51) Int. Cl.: H01L 51/20

(54) **Electroliuminescent device with arylethylene derivatives in hole transport layer**

(30) Priority: 09.12.1998 US 208071
(71) Applicant: EASTMAN KODAK COMPANY, Rochester, New York 14650 (US)
(72) Inventor: Shi, Jianmin, Rochester, New York 14650-2201 (US); Tang, Ching W., Rochester, New York 14650-2201 (US); Chen, Chin H., Rochester, New York 14650-2201 (US)
(74) Representative: Lewandowsky, Klaus, Dipl.-Ing.

(57) **Abstract**

An organic multilayer electroluminescent device including an anode and cathode, and including therebetween a hole transport layer; and an electron transport layer disposed in operative relationship with the hole transport layer; wherein the hole transport layer includes an organic compound having the formula: 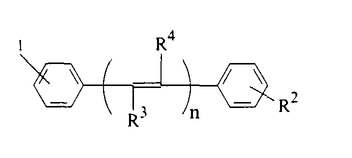 wherein:
n is integer from 1 to 6;
substituents R¹ and R² are each individually hydrogen, or alkyl of from 1 to 24 carbon atoms; aryl or substituted aryl of from 5 to 28 carbon atoms;.or heteroaryl or substituted heteroaryl of from 5 to 28 carbon atoms; or fluorine, chlorine, bromine; or cyano group; and
R³ and R⁴ are each individually hydrogen, or alkyl of from 1 to 24 carbon atoms; aryl or substituted aryl of from 5 to 28 carbon atoms or heteroaryl or substituted heteroaryl of from 5 to 28 carbon atoms.

## Description

The present invention relates to organic electroluminescent devices.

Organic electroluminescent devices are a class of opto-electronic devices where light emission is produced in response to an electrical current through the device. (For brevity, EL, the common acronym for electroluminescent, is sometimes substituted.) The term organic light emitting diode or OLED is also commonly used to describe an organic EL device where the current-voltage behavior is non-linear, meaning that the current through the EL device is dependent on the polarity of the voltage applied to the EL device. In this embodiment, the term EL and EL devices will include devices described as OLED.

Organic EL devices generally have a layered structure with an organic luminescent medium sandwiched between an anode and a cathode. The organic luminescent medium usually refers to an organic light emitting material or a mixture thereof in the form of a thin amorphous or crystalline film. Representatives of earlier organic EL devices are disclosed in US-A-3,172,862; US-A-3,173,050; Dresner, "Double Injection Electroluminescence in Anthracene", RCA Review, Vol. 30, pp. 322-334, 1969; and US-A-3,710,167. In these prior arts, the organic luminescent medium was formed of a conjugated organic host material and a conjugated organic activating agent having condensed benzene rings. Naphthalene, anthracene, phenanthrene, pyrene, benzopyrene, chrysene, picene, carbazole, fluorene, biphenyl, terpheyls, quarterphenyls, triphenylene oxide, dihalobiphenyl, trans-stilbene, and 1,4-diphenylbutadiene were offered as examples of organic host materials. Anthracene, tetracene, and pentacene were named as examples of activating agents. The organic luminescent medium was present as a single layer having a thickness much above 1 micrometer. The voltage required to drive the EL devices was as much as a few hundreds volts, thus the luminous efficiency of these EL devices was rather low.

In commonly-assigned US-A-4,356,429, the art of organic EL device was further advanced by disclosing a bi-layer EL device configuration. The organic luminescent medium in this bi-layer configuration comprises of two extremely thin layers of organic film (<1.0 micrometer in combined thickness) sandwiched between the anode and cathode. The layer adjacent to the anode, termed the hole-transport layer, is specifically chosen to transport predominantly holes only in the EL device. Likewise, the layer adjacent to the cathode is specifically chosen to transport predominantly electrons only in the EL device. The interface or junction between the hole-transport layer and the electron-transport layer is referred to as the electron-hole recombination zone where the electron and hole recombine to produce electroluminescence with the least interference from the electrodes. This recombination zone can be extended beyond the interface region to include portions of the hole-transport layer or the electron-transport layer or both. The extremely thin organic luminescent medium offers reduced electrical resistance, permitting higher current densities for a given voltage applied on the EL device. Since the EL intensity is directly proportional to the current density through the EL device, this thin bi-layer construction of the organic luminescent medium allows the EL device to be operated with a voltage as low as a few volts, in contrast to the earlier EL devices. Thus, the bi-layer organic EL device has achieved a high luminous efficiency in terms of EL output per electrical power input and is therefore useful for applications such as flat-panel displays and lighting.

Commonly-assigned US-A-4,356,429 disclosed an EL device formed of an organic luminescent medium including a hole transport layer containing 1000 Angstroms of a porphyrinic compound such as copper phthalocyanine, and an electron transport layer of 1000 Angstroms of tetraphenylbutadiene in poly(styrene). The anode was formed of a conductive indium-tin-oxide (ITO) glass and the cathode was a layer of silver. The EL device emitted blue light when biased at 20 volts at an average current density in the 30 to 40 mA/cm² range. The brightness of the device was 5 cd/m².

Further improvements in the bi-layer organic EL devices were taught by commonly-assigned US-A-4,539,507. Dramatic improvements were realized in EL luminous efficiency by substituting the porphyrinic compounds of Tang in the hole-transport layer with an amine compound. With an aromatic tertiary amine such as 1,1-bis(4-di p-tolylaminophenyl)cyclohexane as the hole-transport layer and an electron transport layer of 4,4'-bis(5,7-di-t-pentyl-2-benzoxazolyl)-stilbene, the EL device was capable of emitting blue-green light with a quantum efficiency of about 1.2 % photon per injected charge when biased at about 20 volts.

The use of aromatic amines as the material for the hole-transport layer in organic EL devices has since been generally recognized as numerous prior arts have disclosed the utility of various classes of amines in enhancing the EL device performance. Improvements in the hole-transport material parameters include higher hole transport mobility, more amorphous structures, higher glass transition temperature, and better electrochemical stability. Improvements in the organic EL devices with these improved amines include higher luminous efficiency, longer operational and storage life, and a greater thermal tolerance. For example, the improved arylamine hole transport materials have been disclosed in commonly-assigned US-A-5,061,569. A series of aromatic amines with glass transition temperature as high as 165 °C designed for high temperature EL devices has been disclosed in commonly-assigned US-A-5,554,450 by Shi et al. A novel π-conjugated starburst molecule 4,4',4''-tris(3-methylphenylamino) triphenylamine (m-MTDATA), which forms a stable amorphous glass and functions as an excellent hole transport material, was disclosed in US-A-5,374,489.

The use of organic compounds outside the aromatic amines class for the hole-transport layer in organic EL devices is not common, given the well-known hole-transport properties of the aromatic amines. However, there is a significant disadvantage of using aromatic amines as the hole-transport layer in the bi-layer EL device. Since amines are generally strong electron donors, they can interact with the emissive materials used in the electron-transport layer, resulting in the formation of fluorescence quenching centers and a reduction in the EL luminous efficiency.

It is an object of the present invention to provide organic compounds outside the class of aromatic amines as the hole transport layer in organic EL devices, which result in enhanced EL performance.

This object is achieved in An organic multilayer electroluminescent device including an anode and cathode, and comprising therebetween:
a hole transport layer; and
an electron transport layer disposed in operative relationship with the hole transport layer;
   wherein:
   the hole transport layer includes:
      Compounds having the formula I: 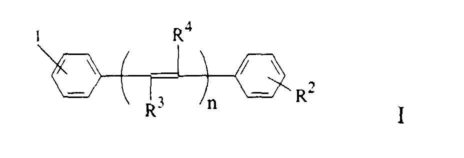 wherein:
         n is integer from 1 to 6;
         substituents R¹ and R² are each individually hydrogen, or alkyl of from 1 to 24 carbon atoms; aryl or substituted aryl of from 5 to 28 carbon atoms;.or heteroaryl or substituted heteroaryl of from 5 to 28 carbon atoms; or fluorine, chlorine, bromine; or cyano group; and
         R³ and R⁴ are each individually hydrogen, or alkyl of from 1 to 24 carbon atoms; aryl or substituted aryl of from 5 to 28 carbon atoms or heteroaryl or substituted heteroaryl of from 5 to 28 carbon atoms;
      Further compounds that can be used as hole transport material have formulas II-IV: 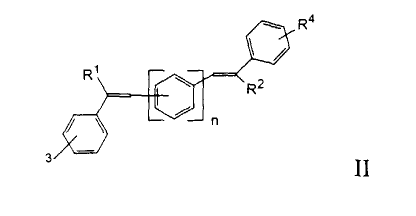 wherein:
         n is integer from 1 to 6;
         substituents R¹ and R² are each individually hydrogen, or alkyl of from 1 to 24 carbon atoms; aryl or substituted aryl of from 5 to 28 carbon atoms or heteroaryl or substituted heteroaryl of from 5 to 28 carbon atom; and
         R³ and R⁴ are each individually hydrogen, or alkyl of from 1 to 24 carbon atoms; aryl or substituted aryl of from 5 to 28 carbon atoms;.or heteroaryl or substituted heteroaryl of from 5 to 28 carbon atoms; or fluorine, chlorine, bromine; or cyano group;
      Arylethylene derivatives having formulae III: 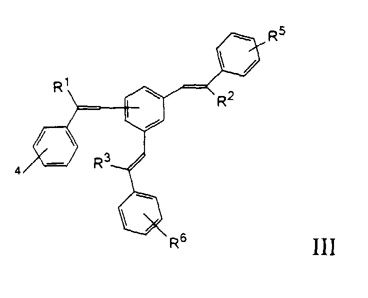 wherein:
         n is integer from 1 to 6;
         substituents R¹, R² and R³ are each individually hydrogen, or alkyl of from 1 to 24 carbon atoms; aryl or substituted aryl of from 5 to 28 carbon atoms or heteroaryl or substituted heteroaryl of from 5 to 28 carbon atom; and
         R⁴, R⁵ and R⁶ are each individually hydrogen, or alkyl of from 1 to 24 carbon atoms; aryl or substituted aryl of from 5 to 28 carbon atoms;.or heteroaryl or substituted heteroaryl of from 5 to 28 carbon atoms; or fluorine, chlorine, bromine; or cyano group;
      Aryleacetylene derivatives having formulae IV: 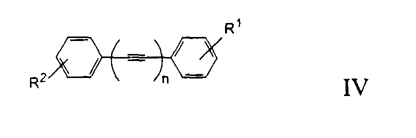 wherein:
         n is integer from 1 to 6;
         substituents R¹ and R² are each individually hydrogen, or alkyl of from 1 to 24 carbon atoms; aryl or substituted aryl of from 5 to 28 carbon atoms;. or heteroaryl or substituted heteroaryl of from 5 to 28 carbon atoms; or fluorine, chlorine, bromine; or cyano group.
      Arylethylene and arylacetylene derivatives that are used in the hole transporting layer have the feature that do not need to include alkylamino- or arylamino- moieties;

The arylethylene and arylacetylene derivatives in accordance with the present invention have an ionization potential larger than 5.0 eV.

The hole transport layer in accordance with the present invention effectively works with the electron transport layer or an emissive layer or an electron transport layer which also functions as an emissive layer to provide a highly efficient electroluminescent device.
FIG. 1 illustrates the cross-section of a bi-layer organic EL device;
FIG. 2 illustrates the cross-section of an EL device with a modified bi-layer structure; and
FIG. 3 illustrates the energy level diagram of an organic EL device with a bi-layer structure as described in FIG. 1.

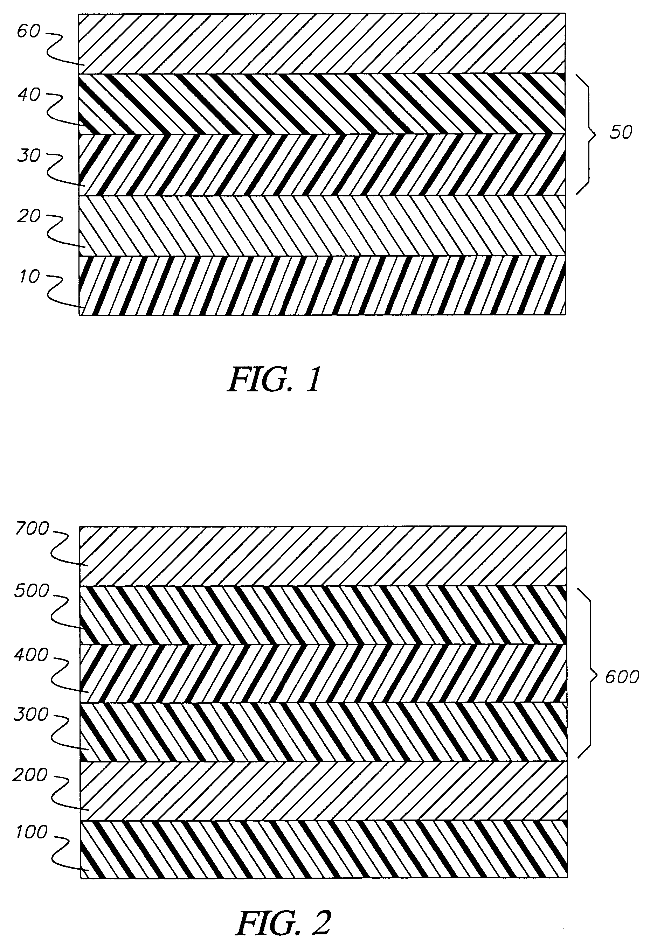

FIG. 1 illustrates the basic structure used in the construction of organic EL device of this invention. It is a bi-layer structure comprising an organic hole transport layer 30 and an organic electron transport layer 40. The electron transport layer is also the emissive layer from which electroluminescence originates. Together, they form the organic EL medium 50. The anode 20 is adjacent to the hole transport layer and the cathode 60 is adjacent to the electrode transport layer. The substrate is layer 10. This figure is for illustration only and the individual layer thickness is not scaled according to the actual thickness.

FIG. 2 illustrates an alternative construction of the organic EL device of this invention. It is a modified bi-layer structure. The EL medium contains an emissive layer between the hole transport layer and the electron transport layer. This emissive layer is the layer from which electroluminescence originates. Thus, layer 300 is the hole transport layer, layer 400 is the emissive layer, layer 500 is the electron transport layer, and together they form the electroluminescent medium 600. Layer 200 is the anode and layer 700 is the cathode. The substrate is layer 100. This figure is for illustration only and the individual layer thickness is not scaled according to the actual thickness.

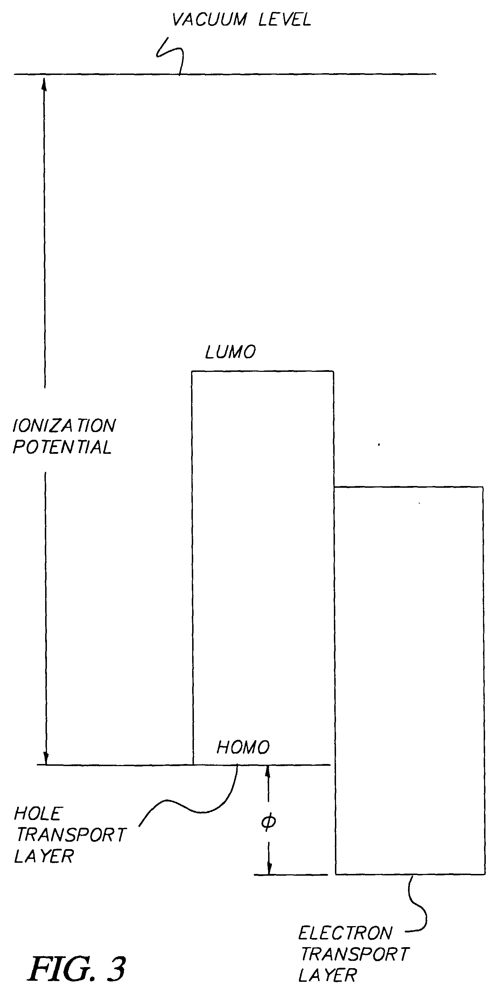

FIG. 3 illustrates the energy level diagram of an organic EL device with a bi-layer structure as described in FIG. 1. The organic EL medium is represented by a hole-transport layer with a characteristic low ionization potential energy, and an electron transport layer with a relatively higher ionization potential energy. The ionization potential energy or ionization potential (IP) for a molecular solid is defined as the energy difference between the vacuum level and the highest occupied molecular orbital (HOMO) level of the solid. The vacuum level is usually referred to as the reference level from which the energy levels of the molecular solid are measured. The HOMO is the highest energy level filled with electron and in which the hole is free to move. Similarly, the lowest unoccupied molecular orbital (LUMO) is the lowest energy level devoid of electron and in which free electron is free to move. The energy difference between HOMO and LUMO is the bandgap within which there are no available molecular orbital states. The IP value is a measure of the minimum energy required to remove an electron from the molecular solid and can be easily obtained experimentally by photoemission techniques which have been well described in the literature.

The bi-layer structure as illustrated in FIG. 1 is designed to confine the electron hole recombination at the interface between the hole transport layer and the electron transport layer. This confinement is accomplished by establishing either an electron injection barrier or a hole injection barrier or both at the interface. Referring to the hole injection barrier, it is the difference between the HOMO levels of the hole transport and electron transport layers, as indicated by the symbol, φ, in FIG. 3. For large φ values, > 0.5 eV, the hole migrating through the hole transport layer towards the interface will be unable to overcome the potential energy barrier and will thus be trapped at the hole transport layer side of the interface. Likewise, the electron injection barrier is the difference between the LUMO levels and a large electron injection barrier for electron injection will localize the electron at the electron transport layer side of the interface. As a result of these charge localizations created by a proper choice of the hole transport and electron transport materials, the electron hole pair will tend to recombine at the interface producing electroluminescence which is characteristics of the interface.

Conventional hole transport materials used in EL devices are mostly arylamines because their hole mobility is among the highest found in common organic materials. Materials with a high mobility are desirable for current-driven devices such as organic EL as the voltage require to operate the device will be low. The arylamines are also known to have the lowest ionization potentials among organic materials. Thus, for creating a hole injection barrier between the hole transport layer and the electron transport layer in a bi-layer EL device, arylamines are appropriate. Highly efficient EL devices have been produced using a variety of arylamines as the hole transport layer.

A class of arylamines found particularly useful in organic EL devices is represented by formula V: 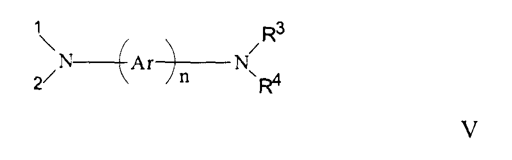 wherein
Ar is an arylene group, and arylene moieties are preferably phenyl and phenylene moieties.
n is an integer of from 1 to 4, and
R¹, R², R³ and R⁴ are independently selected aryl groups.

These arylamines are particularly useful as the hole transport material in EL devices.

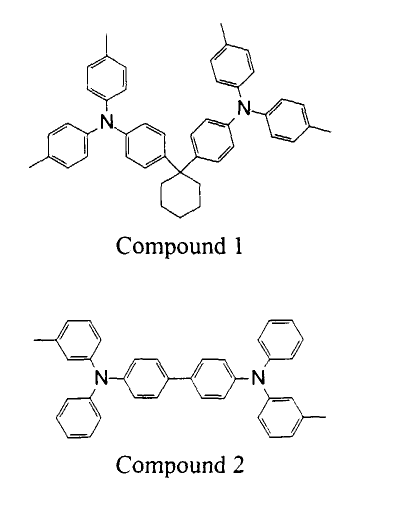

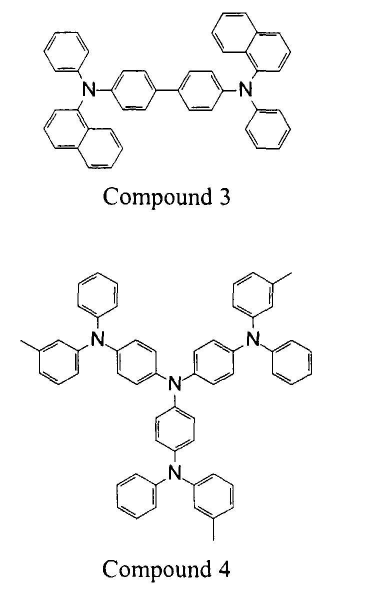

Although arylamines are useful as hole transport materials in EL devices, they do have a number of deficiencies. First, as a class of organic materials, they are relatively strong electron donors, meaning that they can be easily oxidized and therefore are unstable in amibient environments. Second, when used as a hole transport layer adjacent to an electron transport layer in an EL device, the arylamines may interact with the electron transport layer to produce non-emissive centers which will result in a loss of electroluminescence. Third, because of the low ionization potential of the arylamines, the hole injection barrier formed between the arylamine hole transport layer and the electron transport layer will cause the holes to localize in the arylamines which will also result in a loss of electroluminescence. For these reasons, new hole transport materials are useful to further improve the EL device performance.

The new hole transport materials in this invention include arylethylene and arylacetylene derivatives with a molecular structure containing at least 20 carbon atoms;

A representative class of the hole transport materials includes:
a) Arylethylene derivatives of formulae I: 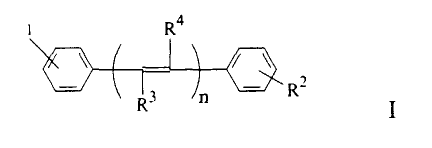 wherein:
   n is integer from 1 to 6;
   substituents R¹ and R² are each individually hydrogen, or alkyl of from 1 to 24 carbon atoms; aryl or substituted aryl of from 5 to 28 carbon atoms; or heteroaryl or substituted heteroaryl of from 5 to 28 carbon atoms; or fluorine, chlorine, bromine; or cyano group; and
   R³ and R⁴ are each individually hydrogen, or alkyl of from 1 to 24 carbon atoms; aryl or substituted aryl of from 5 to 28 carbon atoms or heteroaryl or substituted heteroaryl of from 5 to 28 carbon atoms.

   The following molecular structures constitute specific examples of arylethylene derivatives represented by the general formula I. These compounds are particularly useful as the hole transport material in EL devices. 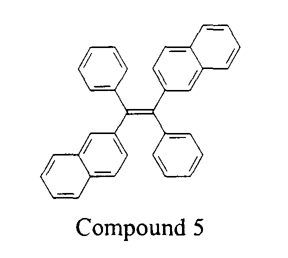 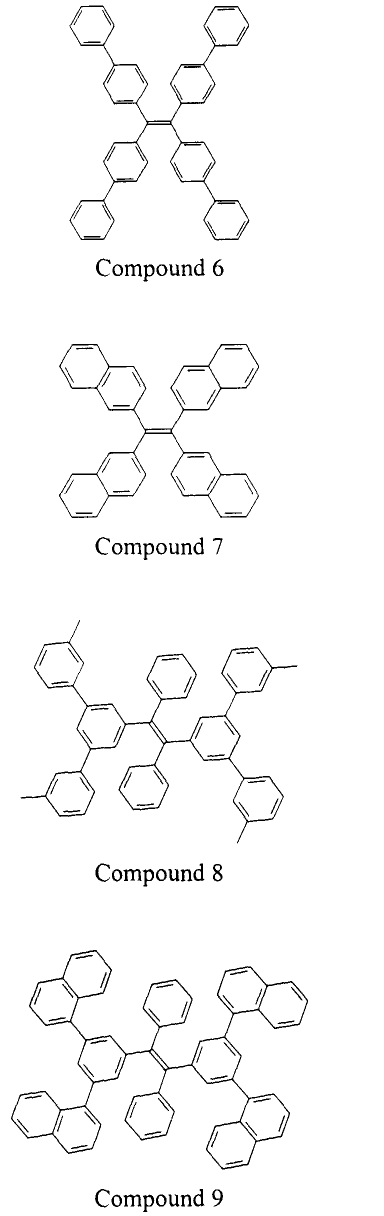 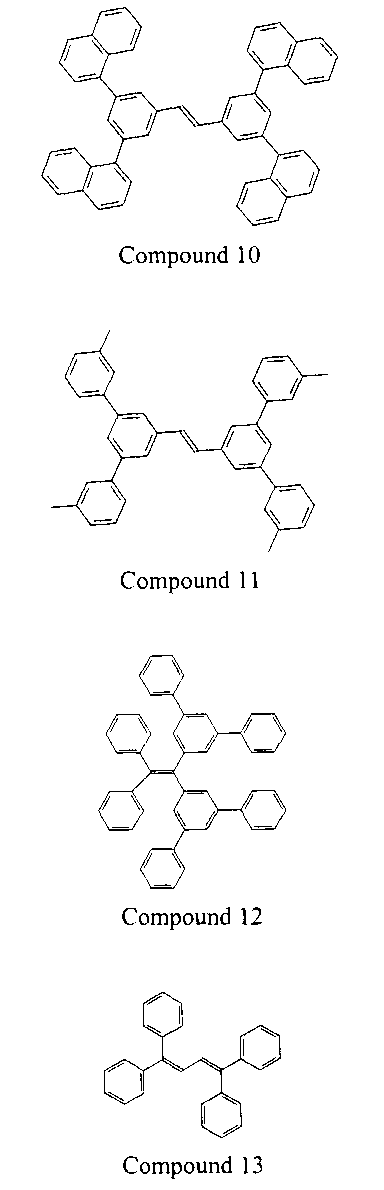 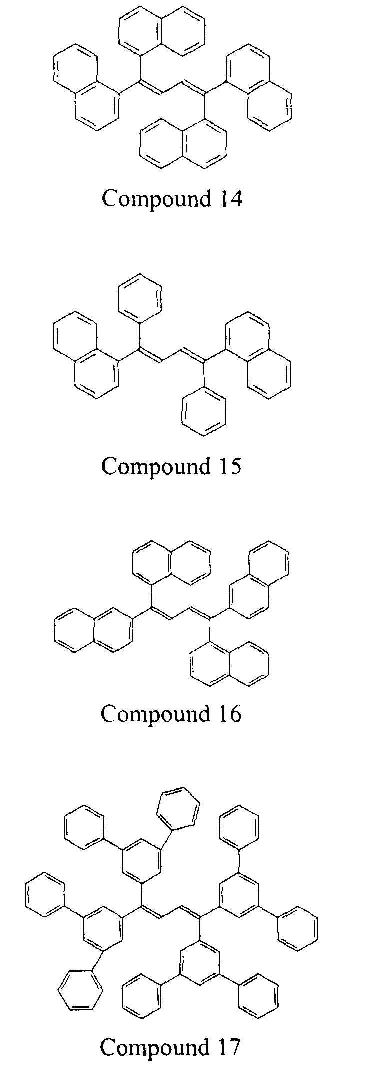
b) Arylethylene derivatives having formulae II: 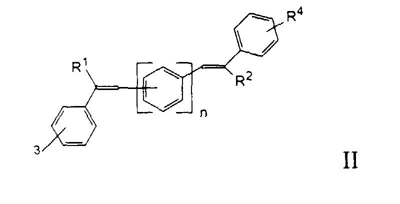 wherein:
   n is integer from 1 to 6;
   substituents R¹ and R² are each individually hydrogen, or alkyl of from 1 to 24 carbon atoms; aryl or substituted aryl of from 5 to 28 carbon atoms or heteroaryl or substituted heteroaryl of from 5 to 28 carbon atom; and
   R³ and R⁴ are each individually hydrogen, or alkyl of from 1 to 24 carbon atoms; aryl or substituted aryl of from 5 to 28 carbon atoms; or heteroaryl or substituted heteroaryl of from 5 to 28 carbon atoms; or fluorine, chlorine, bromine; or cyano group.

   The following molecular structures constitute specific examples of arylethylene derivatives represented by the general of formula II. These compounds are particularly useful as the hole transport material in EL devices. 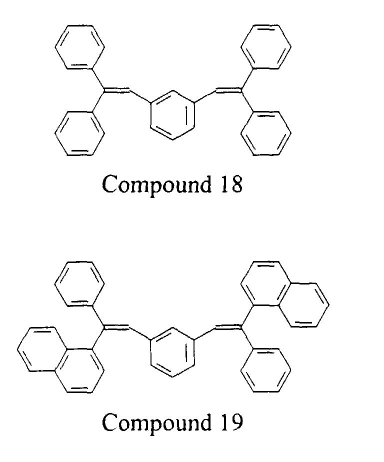 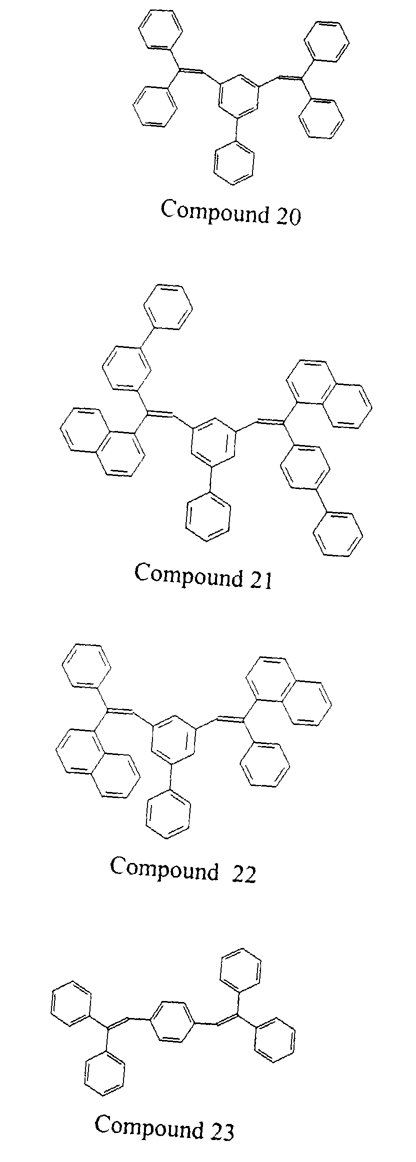 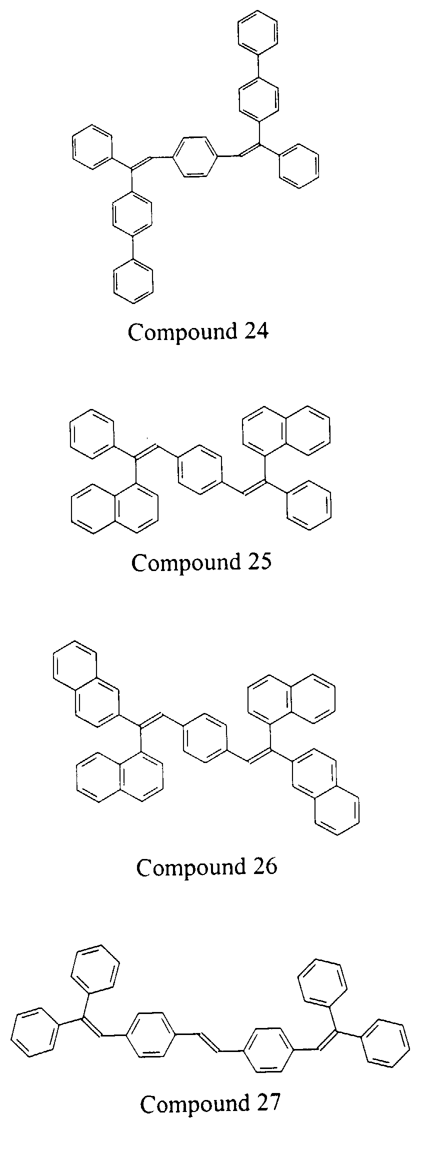 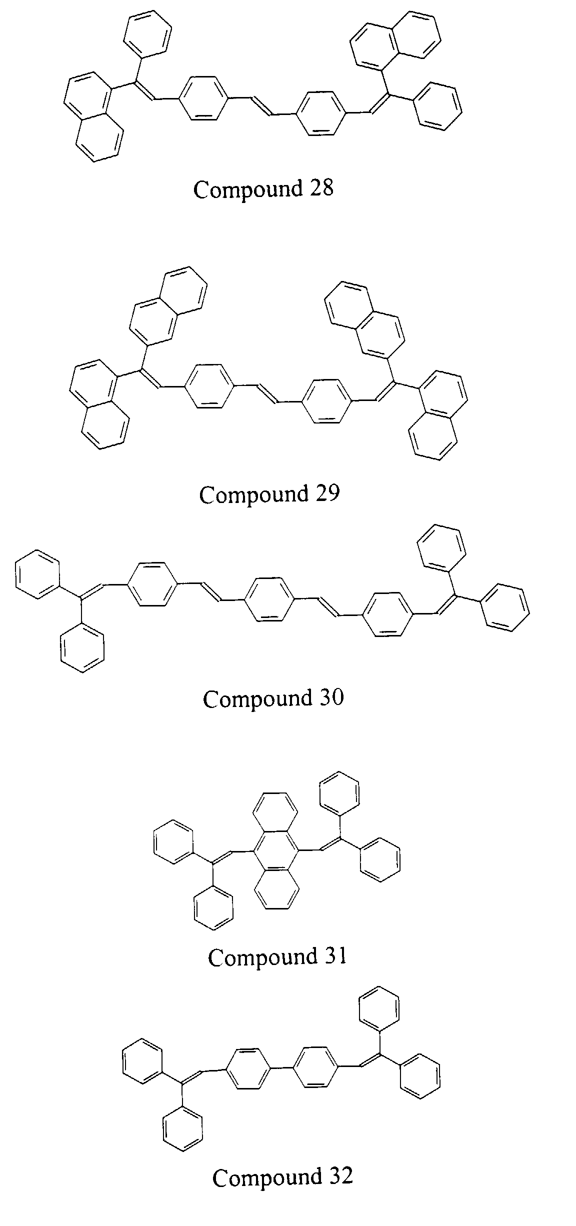 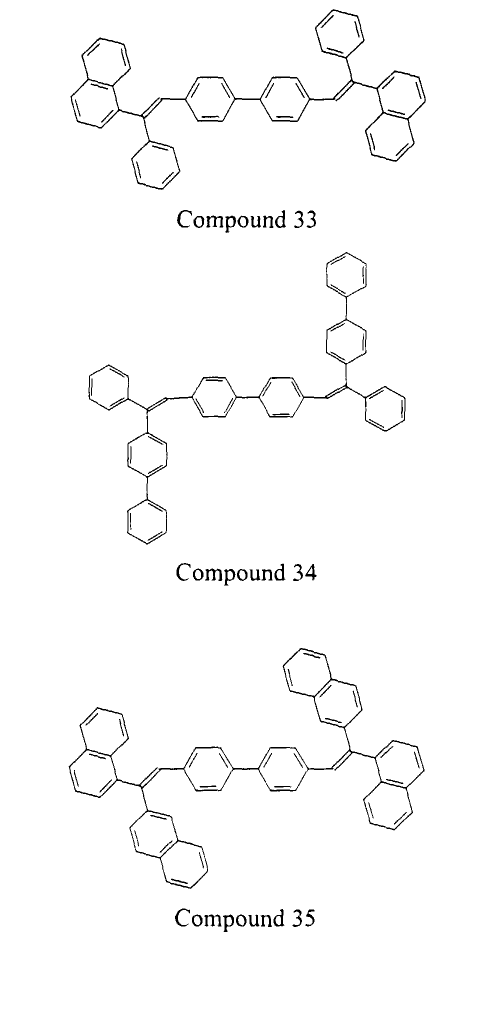 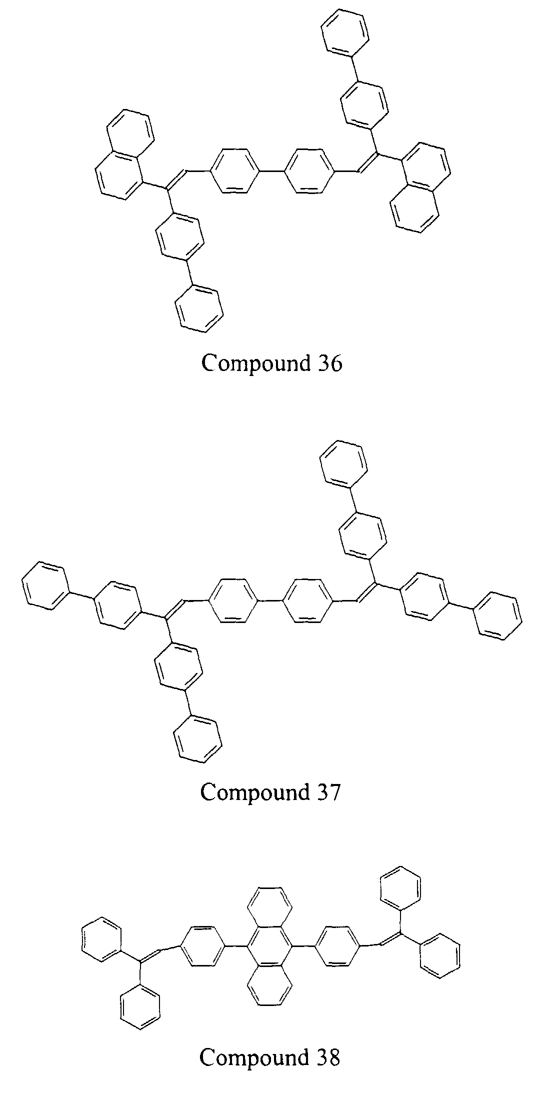 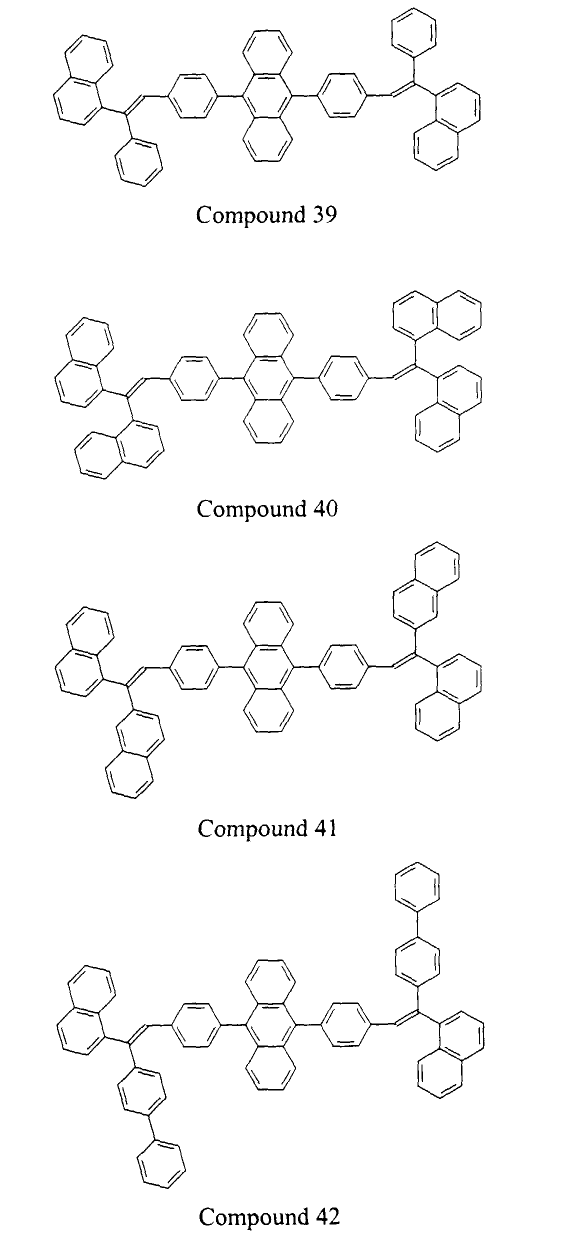 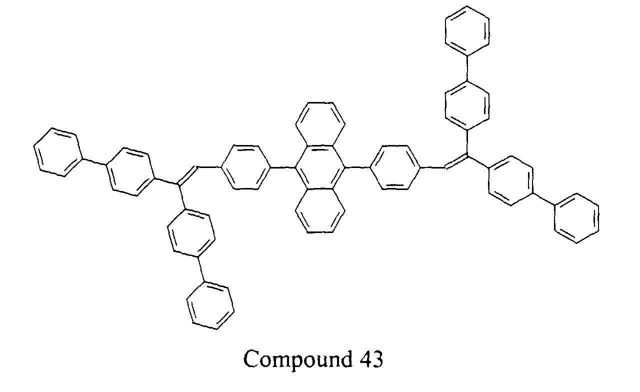
c) Arylethylene derivatives having formulae III: 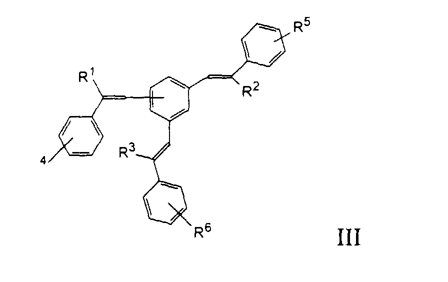 wherein:
   n is integer from 1 to 6;
   substituents R¹, R² and R³ are each individually hydrogen, or alkyl of from 1 to 24 carbon atoms; aryl or substituted aryl of from 5 to 28 carbon atoms or heteroaryl or substituted heteroaryl of from 5 to 28 carbon atom; and
   R⁴, R⁵ and R⁶ are each individually hydrogen, or alkyl of from 1 to 24 carbon atoms; aryl or substituted aryl of from 5 to 28 carbon atoms; or heteroaryl or substituted heteroaryl of from 5 to 28 carbon atoms; or fluorine, chlorine, bromine; or cyano group.

   The following molecular structures constitute specific examples of arylethylene derivatives represented by the general of formula III. These compounds are particularly useful as the hole transport material in EL devices. 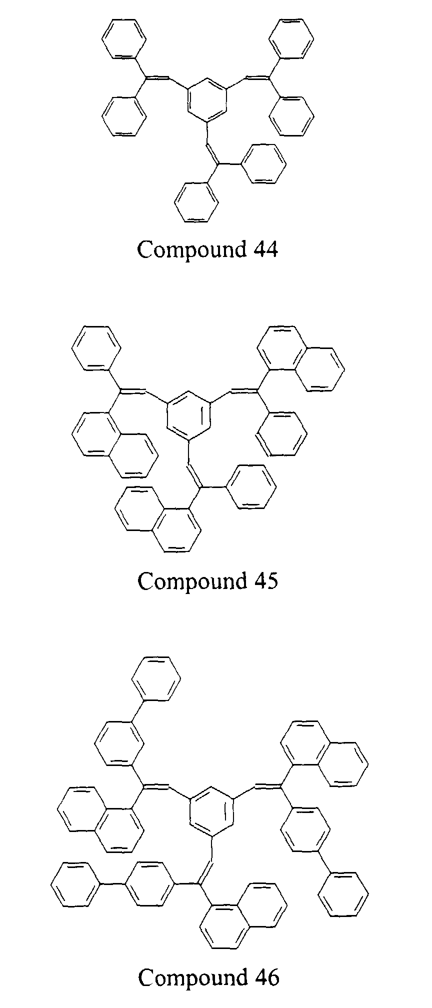 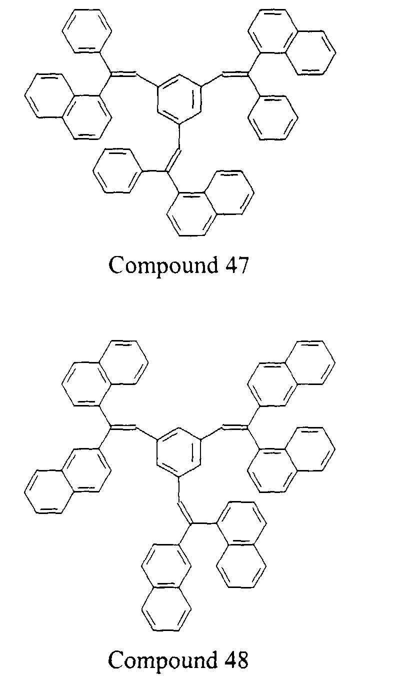
d) Aryleacetylene derivatives of formulae IV: 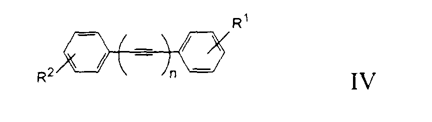 wherein:
   n is integer from 1 to 6;
   substituents R¹ and R² are each individually hydrogen, or alkyl of from 1 to 24 carbon atoms; aryl or substituted aryl of from 5 to 28 carbon atoms;. or heteroaryl or substituted heteroaryl of from 5 to 28 carbon atoms; or fluorine, chlorine, bromine; or cyano group.

The following molecular structures constitute specific examples of arylacetylene derivatives represented by the general of formula IV. These compounds are particularly useful as the hole transport material in EL devices.

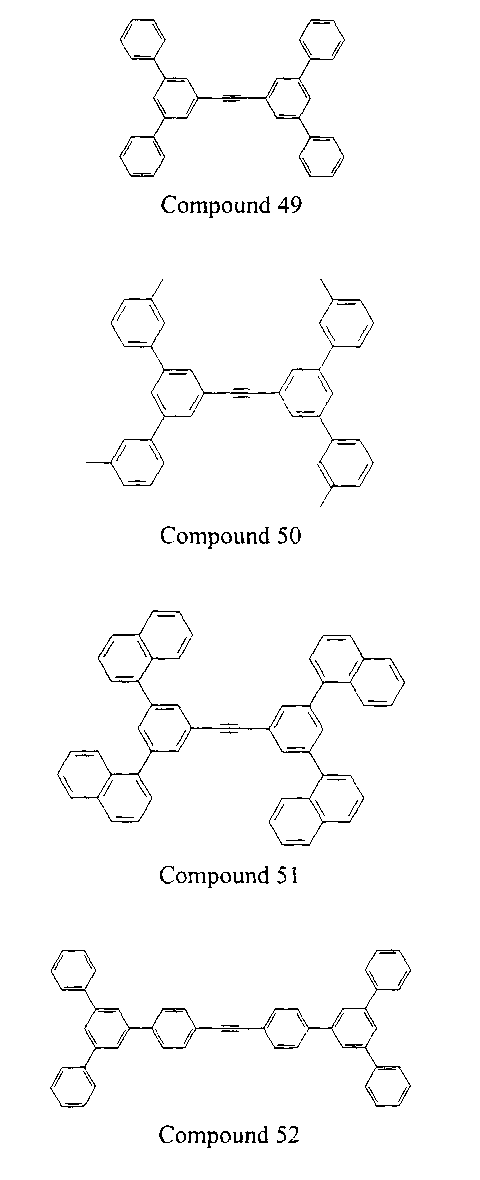

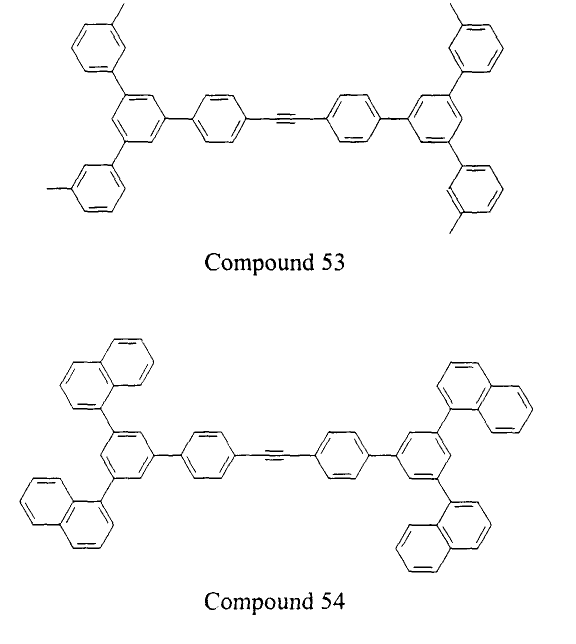

The ionization potentials of some of these aromatic hydrocarbon hole transport materials have been measured and their values are compared with the arylamine hole transport materials as follows. It is noted that the aromatic hydrocarbon hole transport materials generally have a higher ionization potential than the arylamines.

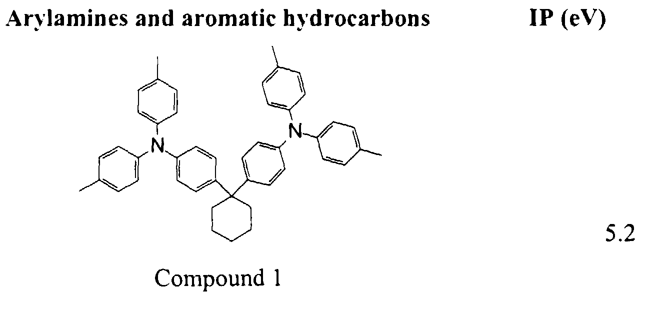

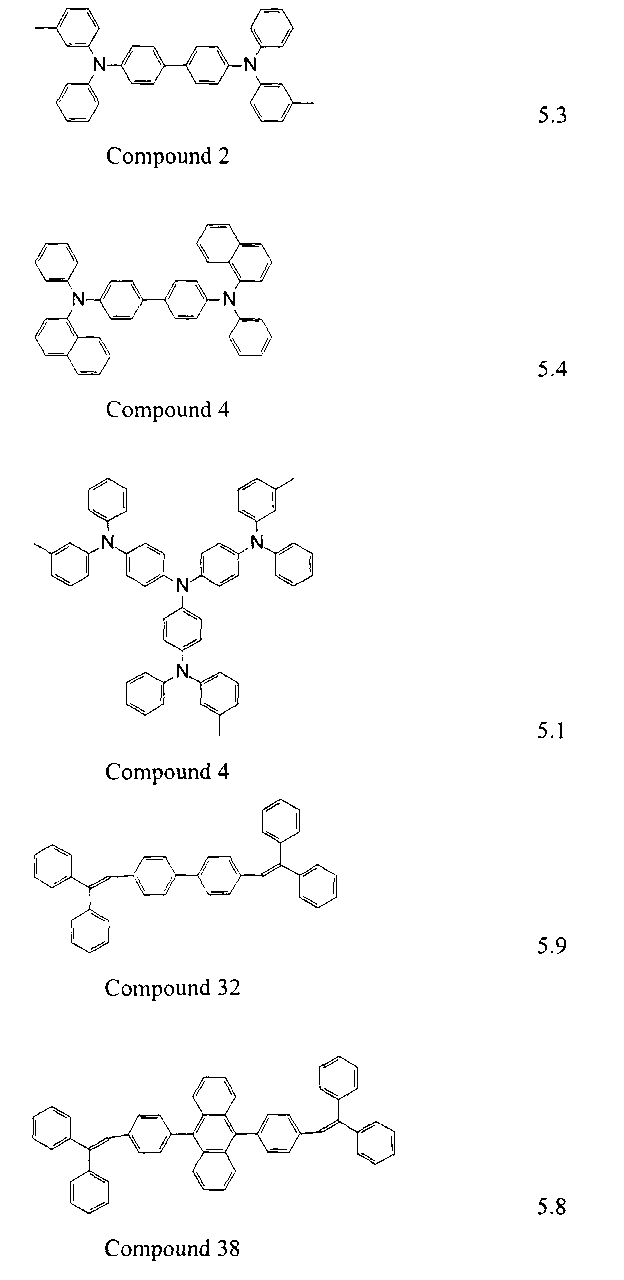

A higher ionization potential for the hole transport material is more favorable for hole injection from the hole transport layer to the electron transport layer in a bi-layer EL device resulting in a lower hole injection barrier and consequently a higher EL luminous efficiency. A preferred range for the ionization potentials is 5.0 eV or higher. An alternative criteria is that it should be as high as the ionization potential of the electron transport material in the bi-layer EL device.

In forming the hole transport layer of the organic EL device, the hole transport materials of this invention can be deposited by a number of methods. The preferred method is by vacuum vapor deposition as these aromatic hydrocarbons have good thermal stability and can be sublimed into thin film. Alternately, they can be dissolved in appropriate solvents and be cast into thin film. Other deposition methods such as printing by the inkjet method, thermal transfer, laser abrasion and sputtering are useful.

The bi-layer EL device is the basic structure providing high luminous efficiencies and low-voltage operation. Alternative EL device structures have been demonstrated providing improved device performance. These alternative device structures include features in addition to the basic bi-layer structure such as the following structure (a) hole injection layer as disclosed in US-A-4,356,429; (b) cathode modification with alkaline or alkaline halides as disclosed in US-A-5,776,622; (c) anode modification with plasma-deposited flurocarbons, and (d) doped emitter layer inserted between the hole transport and electron transport layer as disclosed in US-A-4,769,292. These EL device structures retain the hole transport layer as one component of the electroluminescent medium. Therefore, the aromatic hydrocarbon or fused hydrocarbon hole transport materials disclosed in this invention are applicable to these EL device structures as well.

A preferred EL device structure comprises an anode, a hole transport layer, an emissive layer, and an electron transport layer. In this preferred EL structure, the emissive layer is capable of transporting electrons as well, thus it can be considered as an electron transport layer with the added function of being highly luminescent. The principle function is to provide efficient emissive centers for electroluminescence. This emissive layer comprises a host material doped with one or more fluorescent dyes (FD). The fluorescent dye is usually present in an amount on the order of a few mole percent or less of the host material and it is sufficient to cause the EL emission to be predominantly that of the fluorescent dye. Using this method, highly efficient EL devices can be constructed. Simultaneously, the color of the EL devices can be tuned by using fluorescent dyes of different emission wavelengths. By using a mixture of fluorescent dyes, EL color characteristics of the combined spectra of the individual fluorescent dyes are produced. This dopant scheme has been described in considerable details for EL devices in commonly-assigned US-A-4,769,292.

An important relationship for choosing a fluorescent dye as a dopant capable of modifying the hue of light emission when present in a host material is a comparison of their bandgap potential which is defined as the energy difference between the highest occupied molecular orbital and the lowest unoccupied molecular orbital of the molecule.

Preferred host materials for the emissive layer of the organic EL device disclosed in this invention are metal chelated oxinoid compounds, including chelates of oxine itself (also commonly referred to as 8-quinolinol or 8-hydroxyquinoline or Alq). Another class of preferred host materials is a mix ligand 8-quinolinolato aluminum chelates which have been disclosed in US-A-5,141,671. Another class of preferred host materials is distrylstibene derivatives as disclosed in US-A-5,366,811.

For efficient energy transfer from the host to the dopant molecule, a necessary condition is that the band gap of the dopant is smaller than that of the host material. Preferred fluorescent dyes used as the dopant in the emissive layer include coumarins, stilbenes, distrylstilbenes, derivatives of anthracene, tetracene, perylenes, rhodamines, and arylamines

The molecular structures of the preferred fluorescent dyes for the emissive layer in the EL device are listed as follows:

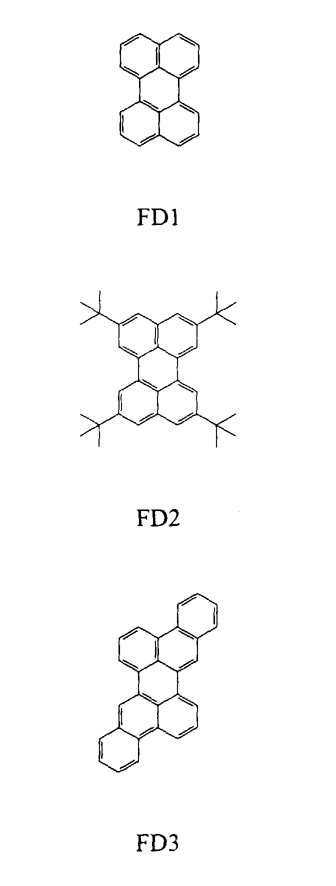

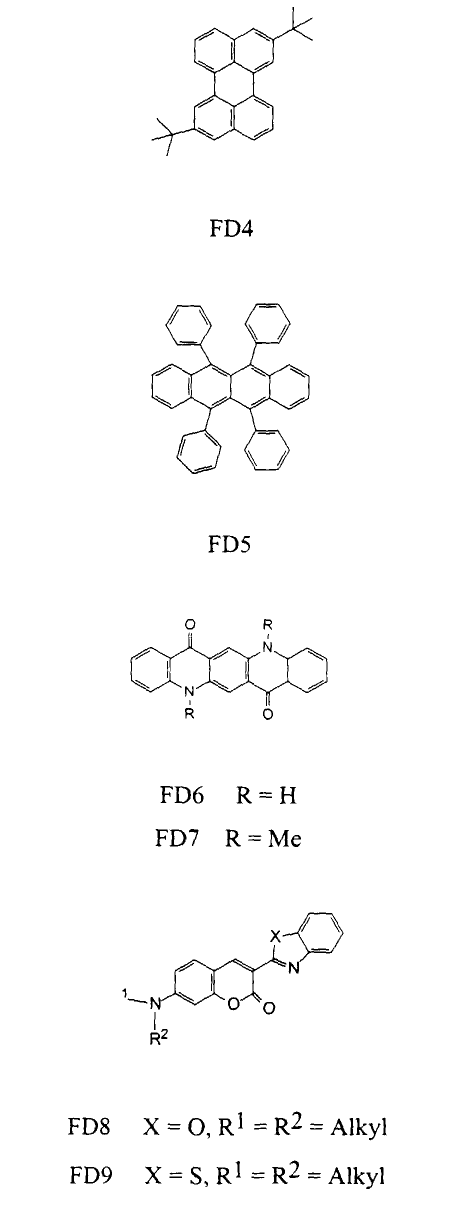

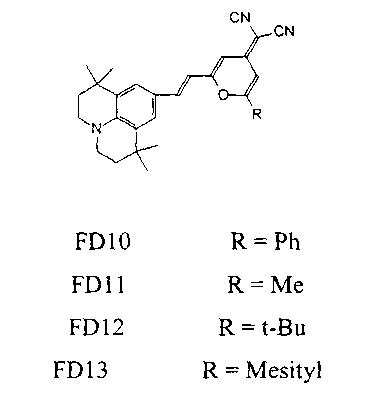

Preferred materials for use in forming the electron transporting layer of the organic EL device are metal chelated oxinoid compounds, including chelates of oxine itself (also commonly referred to as 8―quinolinol or 8―hydroxyquinoline). Representative compounds are 8-hydroquinoline of the group III metals such as Al, In, Mg; and of the group II metals such as Mg, Zn; and of the group I metal such as Li.

Preferred materials for use in forming the cathode of the EL devices of this invention are Mg, Li, or alloys of these materials as disclosed in US-A-5,429,884; and commonly-assigned US-A-5,776,622.

### Examples

The invention and its advantages are further illustrated by the specific examples as follows:

### Material Synthesis:

Most of arylethylene derivatives were prepared in following sequences:

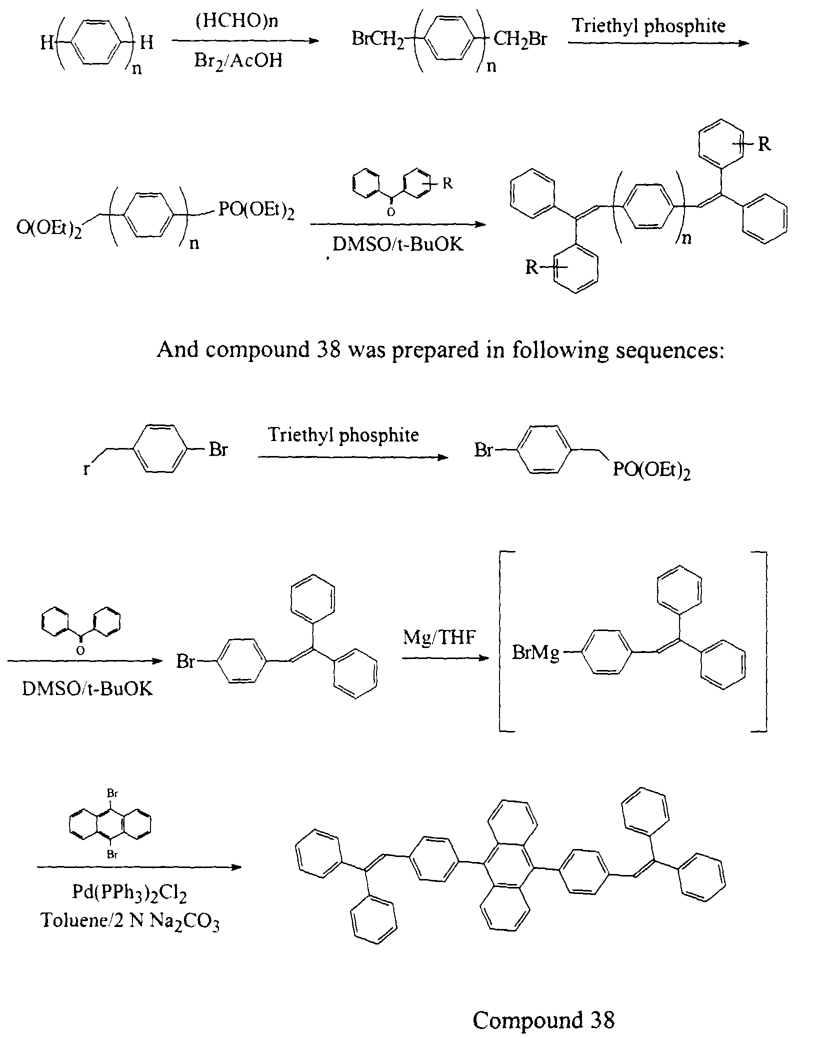

### EL fabrication and performance:

### Examples 1 to 4

EL devices of this invention were constructed in the following manner. The organic EL medium has an anode, a hole transport layer, an emissive and electron transport layer, and a cathode. The substrate was glass.
a) The anode was a conductive indium―tin―oxide (ITO) coated on a glass substrate. It was about 1000 Angstrom thick. The ITO glass was cleaned using a commercial glass plate cleaner. Prior to the deposition of the organic layers, the ITO substrate was subjected to an oxygen plasma clean in a commercial etcher.
b) A hole transport layer about was deposited onto the ITO substrate by vacuum vapor deposition using a tantalum boat source. The layer thickness was about 600 Angstroms.
c) An electron-transport and emissive layer was deposited on top of the hoe transport layer by vacuum vapor deposition using a tantalum boat source. The layer thickness was about 700 Angstroms.
d) A cathode layer was deposited on top of the electron transport and emissive layer. The layer thickness was about 2000 Angstrom and the atomic composition of the cathode was about 10 parts magnesium and 1 part silver.

The above deposition sequence was completed in a single sequence without a vacuum break between the deposition of individual layers. The completed EL device was then sealed with a cover glass plate in a dry glove box for protection against ambient environment. A desiccant material was also include in the sealed package to improve the storage life of the EL device.

The results of the EL devices from examples 1 to 9 are shown in Table I.

**Table I**

| | Hole transport layer | Electron transport and emissive layer | Applied Voltage (V) | Brightness (cd/m2) | Efficiency (cd/A) | Color |
|---|---|---|---|---|---|---|
| Example 1 | Compound 3 | Alq | 7.5 | 578 | 2.9 | Green |
| Example 2 | Compound 13 | Alq | 9.5 | 460 | 2.3 | Green |
| Example 3 | Compound 32 | Alq | 9.0 | 726 | 3.6 | Green |
| Example 4 | Compound 38 | Alq | 7.8 | 836 | 4.2 | Green |

### Examples 5 to 10

EL devices of this invention were constructed in a manner similar to Example 1 - 4. The organic EL medium has an anode, a hole transport layer, an emissive layer, an electron-transport layer, and a cathode. The substrate was glass.
a) The anode was a conductive indium―tin―oxide (ITO) coated on a glass substrate. It was about 1000 Angstroms thick. The ITO glass was cleaned using a commercial glass plate cleaner. Prior to the deposition of the organic layers, the ITO substrate was subjected to an oxygen plasma clean in a commercial etcher.
b) A hole transport layer about was deposited onto the ITO substrate by vacuum vapor deposition using a tantalum boat source. The layer thickness was about 600 Angstroms.
c) An emissive layer was deposited on top of the hole transport layer by vacuum vapor deposition using a tantalum boat source. The layer thickness was about 350 Angstroms.
d) An electron transport layer was deposited on top of the emissive layer by vacuum vapor deposition using a tantalum boat source. The layer thickness was about 350 Angstroms.
e) A cathode layer was deposited on top of the electron transport layer. The layer thickness was about 2000 Angstroms and the atomic composition of the cathode was about 10 parts magnesium and 1 part silver.

The above deposition sequence was completed in a single sequence without a vacuum break between the deposition of individual layers. The completed EL device was then sealed with a cover glass plate in a dry glove box for protection against ambient environment. A desiccant material was also include in the sealed package to improve the storage life of the EL device.

The results of the EL devices from examples 5 to 10 are shown in Table II.

**Table II**

| Examples | Hole transport layer | Doped emissive layer | Electron transport layer | Applied Voltage (V) | Brightness (cd/m2) @ 20 mA/cm^2 | Efficiency cd/A | Emitting Light |
|---|---|---|---|---|---|---|---|
| Example 5 | Compound 3 | Alq + 1% FD 9 | Alq | 8.6 | 2109 | 10.5 | Green |
| Example 6 | Compound 32 | Alq + 1% FD 9 | Alq | 9.5 | 2319 | 11.6 | Green |
| Example 7 | Compound 38 | Alq + 1% FD 9 | Alq | 8.6 | 2465 | 12.3 | Green |
| Example 8 | Compound 3 | Alq+ 1% FD 13 | Alq | 10.2 | 456 | 2.3 | Red |
| Example 9 | Compound 32 | Alq+ 1% FD 13 | Alq | 10.4 | 440 | 2.2 | Red |
| Example 10 | Compound 38 | Alq+ 1% FD 13 | Alq | 10.1 | 445 | 2.3 | Red |

### PARTS LIST

- 10: substrate
- 20: anode
- 30: hole transport layer
- 40: electron transport layer
- 50: organic EL medium
- 60: cathode
- 100: substrate
- 200: anode
- 300: hole transport layer
- 400: emissive layer
- 500: electron transport layer
- 600: EL medium
- 700: cathode

## Claims

1. An organic multilayer electroluminescent device including an anode and cathode, and comprising therebetween:
a hole transport layer; and
an electron transport layer disposed in operative relationship with the hole transport layer; wherein:
the hole transport layer includes an organic compound having the formula: 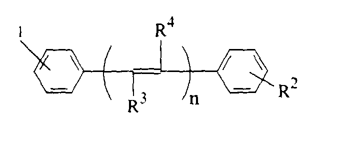 wherein:
n is integer from 1 to 6;
substituents R¹ and R² are each individually hydrogen, or alkyl of from 1 to 24 carbon atoms; aryl or substituted aryl of from 5 to 28 carbon atoms; or heteroaryl or substituted heteroaryl of from 5 to 28 carbon atoms; or fluorine, chlorine, bromine; or cyano group; and
R³ and R⁴ are each individually hydrogen, or alkyl of from 1 to 24 carbon atoms; aryl or substituted aryl of from 5 to 28 carbon atoms or heteroaryl or substituted heteroaryl of from 5 to 28 carbon atoms.

2. An organic multilayer electroluminescent device including an anode and cathode, and comprising therebetween:
a hole transport layer; and
an electron transport layer disposed in operative relationship with the hole transport layer; wherein:
the hole transport layer includes an organic compound having the formula: 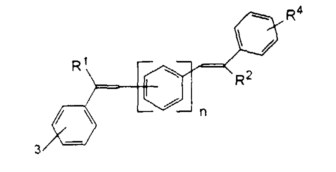 wherein:
n is integer from 1 to 6;
substituents R¹ and R² are each individually hydrogen, or alkyl of from 1 to 24 carbon atoms; aryl or substituted aryl of from 5 to 28 carbon atoms or heteroaryl or substituted heteroaryl of from 5 to 28 carbon atom; and
R³ and R⁴ are each individually hydrogen, or alkyl of from 1 to 24 carbon atoms; aryl or substituted aryl of from 5 to 28 carbon atoms; or heteroaryl or substituted heteroaryl of from 5 to 28 carbon atoms; or fluorine, chlorine, bromine; or cyano group.

3. An organic multilayer electroluminescent device including an anode and cathode, and comprising therebetween:
a hole transport layer; and
an electron transport layer disposed in operative relationship with the hole transport layer; wherein:
the hole transport layer includes an organic compound having the formula: 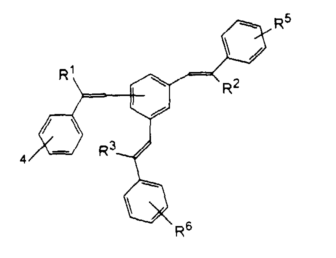 wherein:
n is integer from 1 to 6;
substituents R¹, R² and R³ are each individually hydrogen, or alkyl of from 1 to 24 carbon atoms; aryl or substituted aryl of from 5 to 28 carbon atoms or heteroaryl or substituted heteroaryl of from 5 to 28 carbon atom; and
R⁴, R⁵ and R⁶ are each individually hydrogen, or alkyl of from 1 to 24 carbon atoms; aryl or substituted aryl of from 5 to 28 carbon atoms; or heteroaryl or substituted heteroaryl of from 5 to 28 carbon atoms; or fluorine, chlorine, bromine; or cyano group.

4. An organic multilayer electroluminescent device including an anode and cathode, and comprising therebetween:
a hole transport layer; and
an electron transport layer disposed in operative relationship with the hole transport layer; wherein:
the hole transport layer includes an organic compound having the formula: 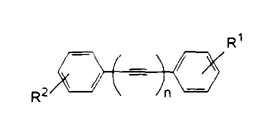 wherein:
n is integer from 1 to 6;
substituents R¹ and R² are each individually hydrogen, or alkyl of from 1 to 24 carbon atoms; aryl or substituted aryl of from 5 to 28 carbon atoms; or heteroaryl or substituted heteroaryl of from 5 to 28 carbon atoms; or fluorine, chlorine, bromine; or cyano group.
